# EUROPÄISCHE PATENTANMELDUNG

(11) **EP 3 012 090 A1**
(43) Veröffentlichungstag der Anmeldung: **27.04.2016**
(21) Anmeldenummer: 15188751.0
(22) Anmeldetag: 07.10.2015
(51) Int. Cl.: B29C 59/14, B05D 3/14, H05H 1/24

(54) **VORRICHTUNG ZUR PLASMABEHANDLUNG VON OBERFLÄCHEN UND EIN VERFAHREN ZUM BEHANDELN VON OBERFLÄCHEN MIT PLASMA**

(30) Priorität: 23.10.2014 DE 102014221521
(71) Anmelder: tesa SE, 22848 Norderstedt (DE)
(72) Erfinder: Hähnel, Marcel, 22851 Norderstedt (DE)

(57) **Zusammenfassung**

Vorrichtung zur Plasmabehandlung von Oberflächen (2) mit einer ersten Elektrode (4) und einer zweiten Elektrode (7) und einer Wechselspannungsquelle (6) zwischen erster (4) und zweiter Elektrode (7) und einem mindestens sich zwischen der ersten (4) und zweiten Elektrode (7) ausbildenden elektrischen Feld, einem vor der ersten Elektrode (4) angeordneten Wirkbereich (9), in dem die zu behandelnde Oberfläche (2) positionierbar ist,und die zweite Elektrode (7) ist dichter am Wirkbereich (9) angeordnet als die erste Elektrode (4), **dadurch gekennzeichnet, dass** wenigstens ein Prozessgaskanal (3) für wenigstens einen Prozessgasstrom mit wenigstens einem Auslass (5) an der ersten Elektrode (4) vorgesehen ist und der wenigstens eine Auslass (5) in Richtung des Wirkbereiches (9) weist und der wenigstens eine Prozessgasstrom das elektrische Feld trifft und das elektrische Feld den wenigstens einen Prozessgasstrom in einen Plasmastrom umwandelt und der Plasmastrom den Wirkbereich (9) trifft.

## Beschreibung

Die Erfindung betrifft eine Vorrichtung zur Plasmabehandlung von Oberflächen mit einer ersten Elektrode und einer zweiten Elektrode und einer Wechselspannungsquelle zwischen erster und zweiter Elektrode und einem sich zwischen der ersten Elektrode und der zweiten Elektrode ausbildenden elektrischen Feld und mit einem vor der ersten Elektrode angeordneten Wirkbereich, in dem die zu behandelnde Oberfläche positionierbar ist, wobei die zweite Elektrode dichter am Wirkbereich angeordnet ist als die erste Elektrode.

Die Erfindung betrifft auch ein Verfahren zur Behandlung von Oberflächen mit Plasma, indem zwischen einer ersten Elektrode und einer zweiten Elektrode eine Wechselspannung angelegt wird, zwischen den beiden Elektroden ein elektrisches Wechselfeld erzeugt wird, vor der ersten Elektrode eine zu behandelnde Oberfläche positioniert wird und die zweite Elektrode dichter an der Oberfläche angeordnet wird als die erste Elektrode.

Grundsätzlich besteht beim Aufeinanderkleben von Oberflächen mittels Klebemassen das Problem, diese dauerhaft und fest auf die Oberfläche des Substrates aufzubringen. Dafür ist eine besonders hohe Adhäsion der Haftklebemasse an der Oberfläche notwendig. Als Adhäsion wird üblicherweise der physikalische Effekt bezeichnet, der den Zusammenhalt zweier miteinander in Kontakt gebrachter Phasen an ihrer Grenzfläche aufgrund dort auftretender intermolekularer Wechselwirkungen beschreibt. Die Adhäsion bestimmt somit das Anhaften der Klebemasse an der Substratoberfläche, die als Anfassklebrigkeit (dem sogenannten "Tack") und als Klebkraft bestimmbar ist. Um die Adhäsion einer Klebemasse gezielt zu beeinflussen, werden der Klebemasse häufig Weichmacher und/oder klebkraftsteigernde Harze (sogenannte "Tackifier") zugesetzt.

Eine einfache Definition der Adhäsion kann "die Wechselwirkungsenergie pro Einheitsfläche" [in mN/m] sein, wobei diese aufgrund experimenteller Einschränkungen wie Unkenntnis der wahren Kontaktflächen nicht messbar ist. Weiterhin wird oft die Oberflächenenergie (OFE) beschrieben mit "polaren" und "unpolaren" Komponenten. Dieses vereinfachende Modell hat sich in der Praxis durchgesetzt. Gemessen werden diese Energie und ihre Komponenten oft mittels Messung der statischen Kontaktwinkel unterschiedlicher Testflüssigkeiten. Den Oberflächenspannungen dieser Flüssigkeiten werden polare und unpolare Anteile zugeordnet. Aus den beobachteten Kontaktwinkeln der Tropfen auf der Prüfoberfläche werden die polaren und unpolaren Anteile der Oberflächenenergie der Prüfoberfläche ermittelt. Dies kann zum Beispiel nach dem OWKR-Modell erfolgen. Eine industriell übliche alternative Methode ist die Bestimmung mittels Testtinten nach DIN ISO 8296.

Im Kontext solcher Diskussionen werden oft die Begriffe "polar" und "hochenergetisch" gleichgesetzt, ebenso die Begriffe "unpolar" und "niederenergetisch". Dahinter steht die Erkenntnis, dass polare Dipolkräfte vergleichsweise stark sind gegenüber sogenannten "dispersen" oder "unpolaren" Wechselwirkungen, die ohne Beteiligung permanenter molekularer Dipole aufbaut werden. Die Grundlage dieses Modells der Grenzflächenenergie und Grenzflächenwechselwirkungen ist die Vorstellung, dass polare Komponenten nur mit polaren wechselwirken und unpolare nur mit unpolaren.

Jedoch kann eine Oberfläche auch kleine oder mittlere polare Anteile an der Oberflächenenergie aufweisen, ohne dass die Oberflächenenergie "hoch" ist. Ein Richtwert kann sein, dass, sobald der polare Anteil der OFE größer ist als 3 mN/m, die Oberfläche im Sinne dieser Erfindung als "polar" zu bezeichnen ist. Dies entspricht in etwa der praktischen unteren Nachweisgrenze.

Grundsätzlich gibt es keine harten Grenzen für Begriffe wie hoch- und niederenergetisch. Für den Zweck der Diskussion wird die Grenze bei 38 mN/m beziehungsweise 38 dyn/cm (bei Raumtemperatur) gesetzt. Dies ist ein Wert, oberhalb dessen beispielsweise die Bedruckbarkeit einer Oberfläche meist hinreichend ist. Zum Vergleich kann man die Oberflächenspannung (=Oberflächenenergie) von reinem Wasser betrachten; diese liegt bei ca. 72 mN/m (unter anderem temperaturabhängig).

Insbesondere auf niederenergetischen Substraten wie PE, PP oder EPDM, aber auch vielen Lacken gibt es große Probleme bei der Erreichung zufriedenstellender Adhäsion, sowohl bei Verwendung von Haftklebemassen als auch anderen Klebstoffen oder Beschichtungen.

Die physikalische Vorbehandlung von Untergründen (zum Beispiel durch Flamme, Corona, Plasma) zur Verbesserung von Verklebungsfestigkeiten ist vor allem bei flüssigen Reaktivklebstoffen üblich. Eine Aufgabe der physikalischen Vorbehandlung kann dabei auch eine Reinigung des Untergrunds sein, beispielsweise von Ölen, oder ein Aufrauen zur Vergrößerung der effektiven Fläche.

Bei einer physikalischen Vorbehandlung spricht man meist von einer "Aktivierung" der Oberfläche. Dies impliziert meist eine unspezifische Wechselwirkung im Gegensatz beispielsweise zu einer chemischen Reaktion nach dem Schlüssel-Schloss-Prinzip. Eine Aktivierung impliziert meistens eine Verbesserung von Benetzbarkeit, Bedruckbarkeit oder Verankerung einer Beschichtung.

Bei Selbstklebebändern ist ein Auftragen eines Haftvermittlers auf den Untergrund üblich. Dies ist aber oft ein fehleranfälliger, aufwändiger, manueller Schritt.

Der Erfolg bei der Verbesserung der Adhäsion von Haftklebemassen durch physikalische Vorbehandlung des Untergrunds (Flamme, Corona, Plasma) ist nicht universell, da unpolare Klebemassen wie zum Beispiel Natur- oder Synthesekautschuk typischerweise nicht davon profitieren.

Eine Coronabehandlung ist als eine durch hohe Wechselspannung zwischen zwei Elektroden erzeugte Oberflächenbehandlung mit filamentären Entladungen definiert, wobei die diskreten Entladungskanäle auf die zu behandelnde Oberfläche treffen, siehe dazu auch Wagner et al., Vacuum, 71 (2003), Seiten 417 bis 436. Ohne weitere Qualifizierung ist als Prozessgas Umgebungsluft anzunehmen.

Insbesondere wird in industriellen Anwendungen meist unter dem Begriff "Corona" eine "dielektrische Barriereentladung" (engl. dielectric barrier discharge, DBD) verstanden. Dabei besteht mindestens eine der Elektroden aus einem Dielektrikum, also einem Isolator, oder ist mit einem solchen beschichtet oder überzogen. Das Substrat kann hierbei auch als Dielektrikum fungieren.

Die Behandlungsintensität einer Coronabehandlung wird als "Dosis" in [Wmin/m²] angegeben, mit der Dosis D=P/b*v, mit P=elektrischer Leistung [W], b=Elektrodenbreite [m], und v=Bahngeschwindigkeit [m/min].

Fast immer wird das Substrat im Entladungsraum zwischen einer Elektrode und einer Gegenelektrode platziert oder hindurchgeführt, was als "direkte" physikalische Behandlung definiert ist. Bahnförmige Substrate werden dabei typischerweise zwischen einer Elektrode und einer geerdeten Walze hindurchgeführt. Manchmal wird noch der Begriff einer "ausgeblasenen Corona" beziehungsweise "einseitigen Corona" verwendet. Dies ist nicht vergleichbar mit einer direkten physikalischen Behandlung, da hier nach dem Stand der Technik hohe Gasströme benötigt werden, um das Plasma als Effluent in Richtung des Substrates aus der Elektrodenanordnung auszutreiben oder so dass unregelmäßige Entladungsfilamente zusammen mit einem Prozessgas "ausgeblasen" werden und keine stabile, wohldefinierte, effiziente Behandlung möglich ist.

Aus der FR 2 443 753 ist eine Vorrichtung zur Oberflächenbehandlung mittels einer Coronaentladung bekannt. Dabei sind die beiden Elektroden auf der gleichen Seite der zu behandelnden Oberfläche des Objektes angeordnet, wobei die ersten Elektroden aus einer Vielzahl von Spitzen gebildet wird, entlang derer eine gekrümmte Anordnung einer zweiten Elektrode vorgesehen ist. Zwischen den beiden Elektroden wird eine Wechselspannung mit 12 Kilovolt bei einer Frequenz von 40 Kilohertz angelegt. Die Coronaentladung entlang der Feldlinien beeinflusst dabei die vorbeigeführte Oberfläche und führt zu einer Aktivierung der Oberfläche, wodurch die Haftungseigenschaften einer Haftklebemasse auf der durch den Coronaeffekt behandelten Oberfläche verbessert werden.

Eine gleichmäßigere intensive Coronabehandlung von Materialien verschiedener Art, Form und Dicke zu ermöglichen, besteht darin, den Coronaeffekt auf der Oberfläche des zu behandelnden Materials völlig zu vermeiden, indem gemäß der EP 0 497 996 B1 eine Doppelstiftelektrode gewählt wird, wobei für jede Stiftelektrode ein eigener Kanal zur Druckbeaufschlagung vorhanden ist. Zwischen den beiden Spitzen der Elektroden entsteht eine Coronaentladung, die den durch die Kanäle strömenden Gasstrom ionisiert und in ein Plasma umwandelt. Dieses Plasma gelangt dann an die zu behandelnde Oberfläche und führt dort insbesondere eine Oberflächenoxidation durch, welche die Benetzbarkeit der Oberfläche verbessert. Die Art der physikalischen Behandlung wird (hier) als indirekt bezeichnet, weil die Behandlung nicht am Erzeugungsort der elektrischen Entladung vorgenommen wird. Die Behandlung der Oberfläche findet bei oder nahe bei Atmosphärendruck statt, wobei jedoch der Druck im elektrischen Entladungsraum oder Gaskanal erhöht sein kann.
Das Plasmagerät der EP 0 497 996 B1 weist recht hohe Gasströme im Bereich von 36 m³ pro Stunde bei 40 cm Elektrodenbreite pro Spalt auf. Aus den hohen Strömungsgeschwindigkeiten resultiert eine geringe Verweilzeit der aktivierten Bestandteile auf der Oberfläche des Substrates. Des Weiteren gelangen auch nur solche Bestandteile des Plasmas bis zum Substrat, die entsprechend langlebig sind und durch einen Gasstrom bewegt werden können. Elektronen beispielsweise können nicht durch einen Gasstrom bewegt werden und spielen dabei also keine Rolle.
Unter dem Plasma wird hier ein Atmosphärendruckplasma verstanden, das ein elektrisch aktiviertes homogenes reaktives Gas ist, das sich nicht im thermischen Equilibrium befindet, mit einem Druck nahe am (+/- 0,05 bar) oder bei Atmosphärendruck beziehungsweise Umgebungsdruck im Wirkbereich. Durch die elektrischen Entladungen und durch Ionisierungsprozesse im elektrischen Feld wird das Gas aktiviert, und es werden hochangeregte Zustände in den Gasbestandteilen erzeugt. Das verwendete Gas und die Gasmischung werden als Prozessgas bezeichnet. Grundsätzlich können dem Prozessgas auch gasförmige Stoffe wie Siloxan, Acrylsäuren oder Lösungsmittel oder andere Bestandteile beigemischt werden. Bestandteile des Atmosphärendruckplasmas können hochangeregte atomare Zustände, hochangeregte molekulare Zustände, Ionen, Elektronen, unveränderte Bestandteile des Prozessgases sein. Das Atmosphärendruckplasma wird nicht in einem Vakuum erzeugt, sondern üblicherweise in Luftumgebung. Das bedeutet, dass das ausströmende Plasma, wenn das Prozessgas nicht selbst schon Luft ist, zumindest Bestandteile der umgebenden Luft enthält oder davon umgeben wird.

Bei einer Coronaentladung nach obiger Definition bilden sich durch die angelegte hohe Spannung filamentäre Entladungskanäle mit Elektronen und Ionen. Insbesondere die leichten Elektronen treffen mit hoher Geschwindigkeit auf die Oberfläche mit Energien, die ausreichen, um die meisten Molekülbindungen aufzubrechen. Die aufgebrochenen Bindungsstellen reagieren dann mit Bestandteilen der Luft oder des Prozessgases weiter. Ein entscheidender Effekt ist die Bildung kurzkettiger Abbauprodukte durch Elektronenbeschuss. Bei Behandlungen höherer Intensität tritt auch ein signifikanter Materialabtrag ein.

Durch die Reaktion eines Plasmas mit der Substratoberfläche werden verstärkt die Plasmabestandteile direkt "eingebaut". Alternativ können auf der Oberfläche ein angeregter Zustand oder eine offene Bindungsstelle und Radikale erzeugt werden, die dann sekundär weiterreagieren, zum Beispiel mit Luftsauerstoff aus der Umgebungsluft. Bei manchen Gasen wie Edelgasen ist keine chemische Bindung der Prozessgasatome oder -moleküle an das Substrat zu erwarten. Hier findet die Aktivierung des Substrats ausschließlich über Sekundärreaktionen statt.

Bei einer indirekten Plasmabehandlung sind freie Elektronen möglicherweise vorhanden, da die Behandlung außerhalb des erzeugenden elektrischen Feldes stattfindet, hängt aber von der Art der Plasmaausbreitung ab.

Es ist Aufgabe der vorliegenden Erfindung, eine Vorrichtung der eingangs genannten Art zur Verfügung zu stellen, die eine indirekte Coronabehandlung einer Oberfläche ermöglicht bei keiner oder einer sehr geringen Strömungsgeschwindigkeit.

Es ist weiterhin Aufgabe der Erfindung, ein Verfahren der eingangs genannten Art zur Verfügung zu stellen, das die genannten Nachteile wie hohe Strömungsgeschwindigkeit und damit hoher Gasverbrauch sowie eine Schädigung der Rückseite des Substrates ebenfalls vermeidet.

Hinsichtlich der Vorrichtung wird die Aufgabe durch eine eingangs genannte Vorrichtung mit den kennzeichnenden Merkmalen des Anspruchs 1 gelöst.

Die Vorrichtung ist gegenüber der FR 2 443 753 als nächstkommender Stand der Technik abgegrenzt. Die erfindungsgemäße Vorrichtung zeichnet sich durch wenigstens einen Prozessgaskanal für wenigstens einen Prozessgasstrom mit einem Auslass pro Spitze an einer ersten Elektrode aus, wobei der Auslass in Richtung des Wirkbereiches weist und der wenigstens eine Prozessgasstrom das elektrische Feld trifft und das elektrische Feld den wenigstens einen Prozessgasstrom in einen, vorzugsweise genau einen Plasmastrom umwandelt und der Plasmastrom den Wirkbereich trifft.

Gegenüber der direkten Coronabehandlung der FR 2 443 753 wird erfindungsgemäß eine Behandlung der Oberfläche eines Substrates mittels eines Plasmastromes vorgenommen, wobei das Plasma vorzugsweise ein Atmosphärendruckplasma ist, aber hier verkürzt als Plasma bezeichnet wird und durch eine Coronaentladung zwischen einer ersten und einer zweiten Elektrode erzeugt wird. Der wenigstens eine Prozessgaskanal verläuft entlang der ersten Elektrode und der wenigstens eine Prozessgasstrom im wenigstens einen Prozessgaskanal wird in einen Plasmastrom umgewandelt. Weil die zweite Elektrode dichter am Wirkbereich angeordnet ist als die erste Elektrode, weisen die Feldlinien der in Betrieb genommenen Vorrichtung vorwiegend eine Richtung zum Wirkbereich auf, so dass selbst bei sehr geringen oder gar keinen Prozessgasstromgeschwindigkeiten eine feldliniengetriebene Fortbewegung des Plasmas in Richtung des Wirkbereiches stattfindet. Dadurch kann die Prozessgasstromgeschwindigkeit vorteilhafterweise verringert werden, und es ist dennoch durch die Plasmabewegung in Richtung des Wirkbereiches eine gezielte Oberflächenaktivierung möglich.

Im erfinderischen Sinn dient das Prozessgas lediglich dazu, besondere Spezies erzeugen zu können.
Vorzugsweise ist die erste Elektrode stabförmig ausgebildet und im Inneren des Prozessgaskanals angeordnet. Bei dieser Ausführungsform sind günstigerweise genau ein Prozessgaskanal und genau ein Prozessgasstrom vorgesehen. Dadurch ist es möglich, dass das Prozessgas die erste Elektrode umlaufend umströmt und zu einem besonders hohen Anteil in Plasma umgewandelt wird. Das Prozessgas dient eben nicht dazu, das Plasma aus der Plasmaquelle in Richtung Substrat auszutreiben.

In einer weiteren Ausführungsform der Erfindung ist die erste Elektrode rohrförmig ausgebildet und umschließt einen weiteren Prozessgaskanal. Die rohrförmige Elektrode ist vorzugsweise weiterhin zentral in dem Prozessgaskanal angeordnet. Der Prozessgaskanal und der weitere Prozessgaskanal sind voneinander getrennt und parallel zueinander ausgerichtet. Dabei ist der weitere Prozessgaskanal im Inneren der rohrförmigen Elektrode vorgesehen, und die Elektrode wird außen von dem Prozessgaskanal ummantelt. Der Prozessgaskanal ist von einer Ummantelung umgeben und durch sie ausgebildet. Vorzugsweise ragt die erste Elektrode dichter an den Wirkbereich heran als die Ummantelung. Die erste Elektrode steht dabei entlang einer Höhenrichtung in Richtung des Wirkbereiches über die Ummantelung hinaus ab.

Es ist jedoch auch möglich, dass die Elektrode in einer anderen Ausführungsform der Erfindung in Höhenrichtung kürzer als die Ummantelung ausgebildet ist, also die Ummantelung dichter an den Wirkbereich heranragt als die erste Elektrode. Die unterschiedliche Länge der Elektrode gegenüber der Ummantelung kann sowohl bei einer stabförmigen als auch rohrförmigen ersten Elektrode gewählt werden.

Durch die unterschiedliche Länge und Anzahl der Prozessgaskanäle ist es möglich, je nach Bedarf eine individuell zugeschnittene Vorrichtung zur Behandlung einer Oberfläche zur Verfügung zu stellen.

Bei beschichtenden Plasmasystemen hat sich gezeigt, dass das auf die Oberfläche des Substrates treffende vom Plasma aktivierte Gas, nachdem es dort eine Abscheidung vorgenommen hat, auch wieder zurück in Richtung Elektroden verwirbelt werden kann und dort ebenfalls im Laufe der Zeit eine Beschichtung ausbildet. Um die Gefahr einer Beschichtung zu verringern oder sogar ganz auszuräumen, ist die zweite Elektrode günstigerweise stabförmig ausgebildet und von einer gasdichten Innenschicht umgeben, und zwischen der gasdichten Innenschicht und einer gasdurchlässigen dielektrischen Außenschicht ist ein Gaskanal vorgesehen. Der Gaskanal ist unabhängig vom Prozessgaskanal. Die zweite Elektrode ist vorzugsweise die geerdete Elektrode. Sie ist von einer gasdichten Innenschicht umgeben, so dass das Gas zwischen der gasdichten Innenschicht und der die gasdichte Innenschicht wiederum ummantelnden gasdurchlässigen dielektrischen Außenschicht nicht zur Elektrode gelangen kann, sondern nur durch die gasdurchlässige dielektrische Außenschicht von der zweiten Elektrode wegströmt. Durch diesen Strom weg von der zweiten Elektrode wird einem Ablagern des reflektierten Plasmas entgegengewirkt.

Besonders bevorzugt weist die Vorrichtung nicht nur eine einzelne erste und genau eine oder genau zwei zweite Elektroden auf, sondern eine Vielzahl an ersten Elektroden in mehreren, jeweils in einer Längsrichtung ausgerichteten Reihen, die hintereinander angeordnet sind und mehrere stabförmige zweite Elektroden, die jeweils entlang einer der Reihen erster Elektroden in Längsrichtung verlaufen. Es ist in dieser Ausführungsform der Erfindung ein ganzes Gitter an ersten Elektroden vorgesehen, wodurch eine großflächige Behandlung der Oberfläche ermöglicht wird.

Hinsichtlich des Verfahrens wird die Aufgabe durch ein eingangs genanntes Verfahren mit den kennzeichnenden Merkmalen des Anspruchs 9 gelöst.

Das Verfahren eignet sich insbesondere zur Durchführung mit einer oder mehreren der oben genannten Vorrichtungen. Bei dem eingangs genannten Verfahren wird wenigstens ein Prozessgasstrom durch wenigstens einen Prozessgaskanal geführt. Der wenigstens eine Prozessgaskanal weist wenigstens einen Auslass auf. Der wenigstens eine Prozessgasstrom verlässt den wenigstens einen Auslass in Richtung des Wirkbereiches, und der wenigstens eine Prozessgasstrom trifft auf das elektrische Feld, und das elektrische Feld wandelt den wenigstens einen Prozessgasstrom in ein Plasmaraum, und das Plasma trifft den Wirkbereich. In dem Wirkbereich wird vorzugsweise die Oberfläche des Substrates angeordnet, und der Plasmastrom trifft auf diese Oberfläche und aktiviert die Oberfläche, indem er die Oberfläche beispielsweise aktiviert oder andere bekannte physikalische Reaktionen an der Oberfläche durchführt, die die Haftkraft eines Haftklebers auf ihr vergrößern. Diese Arten der Aktivierungen sind grundsätzlich aus Jörg Friedrich, "The Plasma Chemistry of Polymer Surfaces", Wiley-VCH Verlag GmbH & Co. KGaA, Weinheim, 2012, bekannt.

Günstigerweise umströmt der Prozessgasstrom die erste stabförmig ausgebildete Elektrode außen; es ist jedoch auch denkbar, dass ein weiterer Prozessgasstrom durch das Innere der röhrenförmig ausgebildeten Elektrode strömt.

In einer Ausführungsform der Erfindung endet der weitere Prozessgasstrom innerhalb der Ummantelung und geht in den Prozessgasstrom über, während in einer anderen Ausführungsform des erfindungsgemäßen Verfahrens die stabförmige Elektrode länger ausgebildet ist als die Ummantelung der Elektrode, so dass der weitere Prozessgasstrom außerhalb der Ummantelung endet und sich erst zu einem späteren Zeitpunkt und in einer geringeren Entfernung zur Oberfläche des Substrates mit dem Prozessgasstrom vermengt.

Günstigerweise ist die zweite Elektrode in einer der oben genannten Ausführungsformen ausgestaltet, und ein Gasstrom strömt entlang der zweiten Elektrode und durch eine gasdurchlässige dielektrische Außenschicht hindurch nach außen, so dass Ablagerungen des Plasmas an der zweiten Elektrode verhindert werden können.

Die Erfindung wird anhand mehrerer Ausführungsbeispiele in sechs Figuren beschrieben, dabei zeigen:
Fig. 1 eine erfindungsgemäße Vorrichtung zur Plasmabehandlung von Oberflächen in einer ersten Ausführungsform,
Fig. 2 eine zweite Ausführungsform der Vorrichtung zur Plasmabehandlung von Oberflächen,
Fig. 3 eine dritte Ausführungsform der Vorrichtung zur Plasmabehandlung von Oberflächen,
Fig. 4 eine vierte Ausführungsform der Vorrichtung zur Plasmabehandlung von Oberflächen,
Fig. 5 eine fünfte Ausführungsform der Vorrichtung zur Plasmabehandlung von Oberflächen
Fig. 6 eine perspektivische Ansicht einer geerdeten Elektrode einer der Ausführungsformen in den Figuren 1 bis 5.

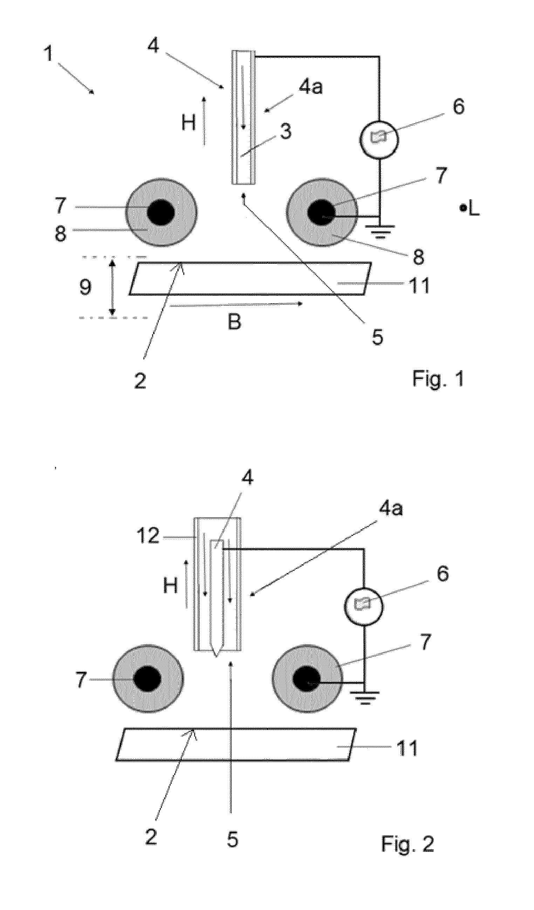

Die in Fig. 1 schematisch dargestellte erste Ausführungsform einer erfindungsgemäßen Vorrichtung 1 zur Plasmabehandlung von Oberflächen 2 weist eine erste Elektrode 4 auf, die rohrförmig ausgebildet ist und in ihrem Inneren einen Prozessgaskanal 3 ausbildet. Die erste Elektrode 4 und ihre Ummantelung fallen in dieser Ausführungsform zusammen. Durch den Prozessgaskanal 3 wird in Betrieb der Vorrichtung ein Prozessgas mit einem geringen Strömungsvolumen von beispielsweise 10 l/min und pro Elektrode beziehungsweise pro Spitze der Elektrode geleitet. Der Prozessgaskanal 3 endet in einer Strömungsrichtung, die einer Höhenrichtung H entgegengesetzt ausgerichtet ist, in einem Auslass 5.

In Fig. 1 ist nur eine Elektrodenspitze 4a der ersten Elektrode 4 dargestellt. Die Elektrodenspitze 4a ist vollständig aus einem leitenden Material, beispielsweise Edelstahl, Eisen oder Kupferlegierungen gefertigt und an eine Wechselspannungsquelle 6 angeschlossen. Die Wechselspannungsquelle 6 erzeugt eine alternierende oder gepulste Hochspannung von 18 kV bis 20 kV bei einer Frequenz von 1 kHz bis 250 kHz. Die Wechselspannungsquelle 6 ist neben der ersten Elektrode 4 an geerdete zweite Elektroden 7 angeschlossen. Die zweiten Elektroden 7 sind in Fig. 1 im Schnitt dargestellt.

Die zweiten Elektroden 7 sind stabförmig ausgeformt und senkrecht zur Papierebene der Fig. 1 in einer Längsrichtung L angeordnet. Die Vorrichtung 1 in Fig. 1 stellt lediglich eine vereinzelte Konfiguration von Elektrodenspitze 4a und von zwei der Elektrodenspitze 4a benachbarten zweiten Elektroden 7 dar. Die gesamte Vorrichtung 1 weist eine Vielzahl von Elektrodenspitzen 4a auf, die in einer Reihe in Längsrichtung L hintereinander angeordnet sind. Der Abstand der Elektrodenspitzen 4a voneinander ist äquidistant, und parallel zur Längsrichtung L der Reihe der Elektrodenspitzen 4a sind zwei stabförmige zweite Elektroden 7 angeordnet. In Fig. 1 ist auf beiden Seiten der Reihe von Elektrodenspitzen 4a jeweils eine zweite stabförmige Elektrode 7 im Querschnitt dargestellt. Beide zweite Elektroden 7 sind mit der Wechselspannungsquelle 6 verbunden Darüber hinaus sind entlang einer Breitenrichtung B, die parallel zur Verbindungslinie zwischen den beiden zweiten Elektroden 7 und senkrecht zur Längsrichtung L und senkrecht zur Höhenrichtung H verläuft, mehrere in Längsrichtung L ausgerichtete Reihen von Elektrodenspitzen 4a angeordnet sein, so dass die Reihen von Elektrodenspitzen 4a parallel zueinander angeordnet sind und zwischen zwei benachbarten Reihen von Elektrodenspitzen 4a jeweils eine geerdete stabförmige zweite Elektrode 7 vorgesehen ist.

An den offenen Enden der röhrenförmigen Elektrodenspitze 4a bildet sich ein elektrisches Feld bei angelegter Wechselspannung aus. Allerdings bilden sich zwischen der Außenwandung der Elektrodenspitze 4a und den beiden zweiten geerdeten Elektroden 7 ein (nicht eingezeichnetes) elektrisches Feld aus, das am Auslass 5 der Elektrodenspitze 4a besonders stark ist. Das heißt, am Auslass 5 der Elektrodenspitze 4a ist ein besonders starkes elektrisches Feld in Betrieb ausgebildet. Die Feldstärke des elektrischen Feldes ist so stark, dass es den aus dem Auslass 5 austretenden Prozessgasstrom in einen Plasmastrom verwandelt. Unter einem Plasma wird hier ein Gemenge aus verschiedenen Bestandteilen verstanden, das hochangeregte atomare Zustände umfasst, hochangeregte molekulare Zustände, Ionen, Elektronen, aber auch unveränderte Bestandteile des Prozessgases. Aufgrund der Ausbildung der Feldlinien in Richtung einer Oberfläche 2 eines Substrats 11 bewegt sich das Plasma bereits feldgetrieben in Richtung des Substrates 11.

Die Elektrodenspitze 4a ist jedoch als von einem Prozessgas durchströmbare Röhre ausgebildet, so dass das Prozessgas, dessen Stromrichtung durch einen Pfeil dargestellt ist, durch die Elektrodenspitze 4a in Richtung des Auslasses 5 strömt und der Auslass 5 in Richtung der Oberfläche 2 des Substrates 11 gerichtet ist, wodurch der Prozessgasstrom in der Röhre, der beim Durchtritt des Auslasses 5 in ein Plasma umgewandelt wird, zum anderen zusätzlich eine Bewegungskomponente in Richtung der Oberfläche 2 des Substrates 11 erhält.

Die Geschwindigkeit des Prozessgasstromes ist nur so groß, dass sich in der Elektrodenspitze 4a eine laminare Strömung ausbildet, die auch nach Verlassen des Auslasses 5 der Elektrodenspitze 4a zumindest im Wesentlichen laminar bleibt und nicht verwirbelt.

Die geerdeten zweiten Elektroden 7 sind von einem nicht leitenden Dielektrikum 8 ummantelt. Das Dielektrikum 8 verhindert einen Funkenüberschlag zwischen Elektrodenspitze 4a und geerdeten zweiten Elektroden 7 der alternierenden oder gepulsten Hochspannung. In dem nicht leitenden Dielektrikum 8 bildet sich, während die alternierende Hochspannung angelegt ist, eine alternierende Verschiebung der Ladungsträger aus, jedoch findet kein Stromfluss freier Ladungsträger statt, so dass ein durch einen Funkenüberschlag erzeugter Stromfluss unterbunden werden kann.

Die Vorrichtung 1 in Fig. 1 zeigt auch, dass die beiden geerdeten zweiten Elektroden 7 dichter an einem Wirkbereich 9 der Vorrichtung 1 angeordnet sind als der Auslass 5 der Elektrodenspitze 4a. Die sich zwischen der Elektrodenspitze 4a und den beiden geerdeten zweiten Elektroden 7 ausbildenden Feldlinien haben eine Richtung zum Wirkbereich 9 hin. In dem Wirkbereich 9 ist in Fig. 1 das Substrat 11 mit der zu behandelnden Oberfläche 2 dargestellt.

Der Wirkbereich 9 der Vorrichtung 1 ist der dreidimensionale Bereich, in dem die Oberfläche 2 des Substrates 11 angeordnet wird und einer gewünschten und effektiven Behandlung durch einen aus der Elektrodenspitze 4a austretenden Plasmastrom unterzogen werden kann.

Das Prozessgas kann je nach Bedarf verschieden zusammengesetzt sein, insbesondere kann es aus einem hohen Anteil an Stickstoff mit geringen Zusätzen von Edelgasen und Wasserdampf gebildet werden, wobei vorzugsweise 92,4 bis 99,9 Vol.-% Stickstoff, 0,1 bis 10 Vol.- % Edelgase und 0 bis 2,5 Vol.- % Wasserdampf zur Ausbildung des Prozessgases herangezogen werden. Es sind jedoch auch andere Prozessgase denkbar. Grundsätzlich sind alle bei Raumtemperatur (oder etwas tiefer) bis 200 °C gasförmigen Stoffe zusetzbar, die weiterhin auch beschichtende Eigenschaften haben können.

Durch das Plasma wird die Oberfläche 2 in der eingangs beschriebenen Weise aktiviert, wodurch eine Verbesserung der Verklebungsfestigkeit entsteht.

Fig. 2 zeigt eine zweite Ausführungsform der erfindungsgemäßen Vorrichtung 1 zur Plasmabehandlung von Oberflächen 2. Gleiche Bezugszeichen bedeuten in den Figuren 2 bis 6 die gleichen Merkmale wie in Fig. 1.

Auch hier handelt es sich um eine schematische Darstellung, die lediglich eine Elektrodenspitze 4a und zwei geerdete zweite Elektroden 7 im Querschnitt zeigt, wobei die gesamte Vorrichtung 1 auch hier eine Mehrzahl von in Reihe in Längsrichtung L hintereinander senkrecht zur Zeichenebene angeordneten Elektrodenspitzen 4a umfasst, die an beiden Seiten in Längsrichtung L verlaufende geerdete zweite Elektroden 7 aufweisen. In Breitenrichtung B sind wiederum mehrere Reihen von Elektrodenspitzen 4a vorgesehen.

Die Elektrodenspitze 4a der zweiten Ausführungsform umfasst die erste Elektrode 4, die zentral in dem Prozessgaskanal 3 angeordnet ist, die erste Elektrode 4 ist konzentrisch von einer Ummantelung 12 umgeben. Die erste Elektrode 4 und die Ummantelung 12 bilden zusammen die erste Elektrodenspitze 4a aus. Die Elektrodenspitze 4a ist wie auch in den anderen Ausführungsformen im Querschnitt senkrecht zur Höhenrichtung H kreisförmig ausgebildet.

Das Prozessgas strömt in der zweiten Ausführungsform gemäß Fig. 2 entgegengesetzt zur Höhenrichtung H entlang des Prozessgaskanals 3 und tritt aus dem Auslass 5 aus der Elektrodenspitze 4a aus. Im Gegensatz zu Fig. 1 bilden sich die Feldlinien nunmehr nicht zwischen der Ummantelung 12 und den geerdeten zweiten Elektroden 7 aus, sondern zwischen der als Seele 14 in der Elektrodenspitze 4a vorgesehenen ersten Elektrode 4 und den beiden geerdeten zweiten Elektroden 7.

Das mit geringerer Geschwindigkeit austretende Prozessgas kreuzt die Feldlinien des durch die alternierende Hochspannung gebildeten Feldes zwischen erster Elektrode 4 und den beiden zweiten Elektroden 7 und wird in ein Plasma umgewandelt, das sich zum einen feldgetrieben, zum anderen auch durch die aus dem Prozessgas aufgenommene kinetische Energie in Richtung der Oberfläche 2 des Substrates 11 bewegt und die Oberfläche 2 als Plasma erreicht. Das Plasma aktiviert die Oberfläche 2 des Substrates 11. Die erste Elektrode 4 steht entlang der Höhenrichtung H ein Stück weit aus dem Auslass 5 der Elektrodenspitze 4a heraus ab.

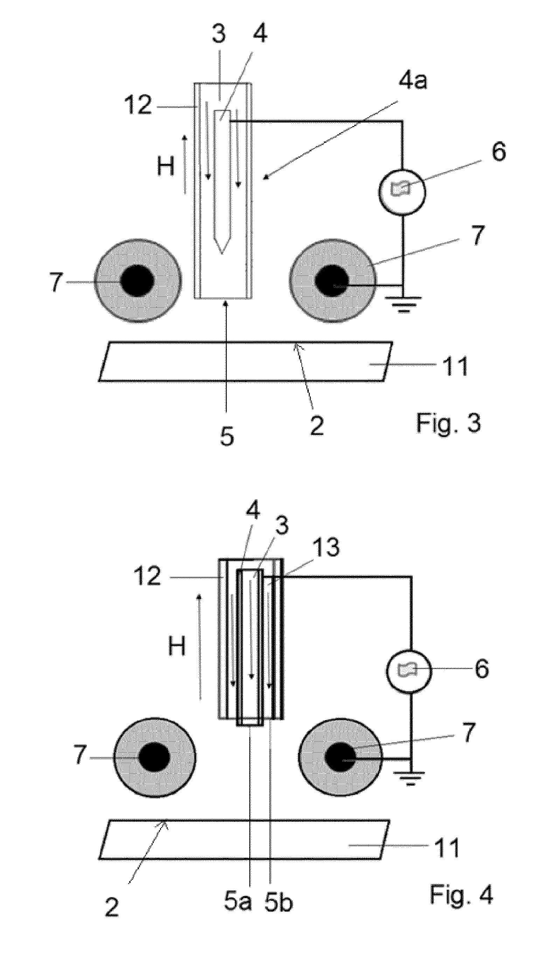

In Fig. 3 ist eine Elektrodenspitze 4a dargestellt, die gegenüber der Elektrodenspitze 4a der zweiten Ausführungsform entgegen der Höhenrichtung H ein Stück weit vor dem Auslass 5 der Elektrodenspitze 4a endet. Die Spitze der ersten Elektrode 4a ist damit innerhalb der Ummantelung 12 der ersten Elektrode 4 angeordnet. Die Ummantelung 12 ist dichter an den Wirkbereich 9 der Vorrichtung 1 herangeführt, so dass der Abstand zwischen Oberfläche 2 des Substrates 11 und Auslass 5 geringer ausfällt als in der Ausführungsform gemäß Fig. 2. Dadurch kann eine begrenzte und noch gezieltere Aktivierung eines begrenzten Bereiches der Oberfläche 2 des Substrates 11 erfolgen.

In der Fig. 4 ist eine vierte Ausführungsform der Vorrichtung 1 zur Plasmabehandlung von Oberflächen 2 dargestellt, die sich wiederum nur in der Bauart der Elektrodenspitze 4a von den anderen Ausführungsformen unterscheidet. Die Elektrodenspitze 4a weist hier eine röhrenförmige erste Elektrode 4 sowie die die röhrenförmige erste Elektrode 4 konzentrische Ummantelung 12 auf. Die erste Elektrode 4 ist an die Wechselspannungsquelle 6 angeschlossen, und sie ist entlang der Höhenrichtung H ein Stück weit über den Auslass 5 der Ummantelung 12 hinaus in Richtung der Oberfläche 2 des Substrates 11 geführt. Der Auslass 5 der ersten Elektrode 4 weist in der Ausführungsform gemäß Fig. 4 zwei unterschiedliche Auslasshöhen 5a, 5b auf, die unterschiedlich weit von der Oberfläche 2 und dem Wirkbereich 9 entfernt sind. Die eine Auslasshöhe 5a wird durch einen Auslass der röhrenförmigen ersten Elektrode 4 gebildet, eine weitere Auslasshöhe 5b durch den Auslass der röhrenförmigen Ummantelung 12 der ersten Elektrode 4. Im Inneren der ersten Elektrode 4 ist der Prozessgaskanal 3 vorgesehen, während zwischen der Außenwandung der ersten Elektrode 4 und der Innenwandung der Ummantelung 12 ein ringförmiger weiterer Prozessgaskanal 13 angeordnet ist. Beim Austritt aus den beiden Auslasshöhen 5a, 5b der Elektrodenspitze 4a werden sowohl das Prozessgas aus dem Prozessgaskanal 3 als auch das aus dem weiteren Prozessgaskanal 13 in ein Plasma umgewandelt und gelangen sowohl feldgetrieben als auch durch die kinetische Energie des Prozessgases selbst getrieben auf die Oberfläche 2 des Substrates 11.

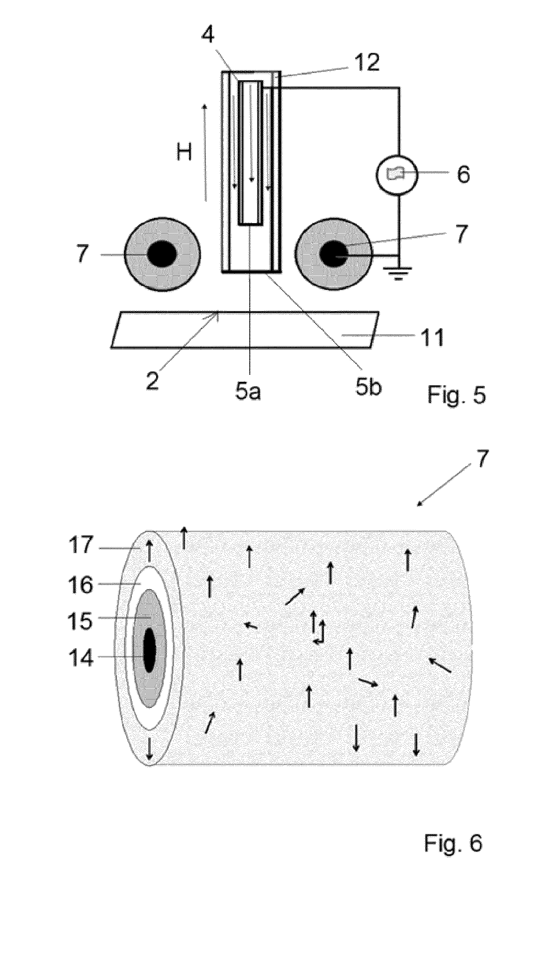

In der in Fig. 5 dargestellten fünften Ausführungsform der Vorrichtung 1 ist die Elektrodenspitze 4a der Fig. 4 wiederum dahingehend abgeändert, dass die Ummantelung 12 entgegengesetzt zur Höhenrichtung H länger ausgebildet ist und dichter an die Oberfläche 2 des Substrates 11 herangeführt ist. Die erste Auslasshöhe 5a der röhrenförmigen ersten Elektrode 4 ist nunmehr weiter von der Oberfläche 2 des Substrates 11 beabstandet als die zweite Auslasshöhe 5b der Ummantelung 12. Im Vergleich zur vieren Ausführungsform ist der Abstand zwischen der zweiten Auslasshöhe 5b und Oberfläche 2 deutlich geringer. Dadurch ist es möglich, das Plasma in einem konzentrierten engeren Bereich auf die Oberfläche 2 des Substrates 11 aufzubringen. Ansonsten entsprechen die Vorrichtungen 1 der Figuren 4 und 5 denen der Fig. 1.

In der Fig. 6 ist eine weitere Ausführungsform der geerdeten zweiten Elektroden 7 der Figuren 1 bis 5 in einer perspektivischen Ansicht dargestellt. Die zweiten Elektroden 7 weisen die leitende, stabförmig ausgebildete Seele 14 auf, die mit dem geerdeten Erdpotential der Wechselspannungsquelle 6 verbunden ist. Die Seele 14 ist von einer gasdichten Innenschicht 15 vollständig ummantelt, und die Innenschicht 15 ist durch einen ringförmigen Gaskanal 16 beabstandet von einer porösen Außenschicht 17 ummantelt. Durch den ringförmigen Gaskanal 16 wird ein Gasstrom geleitet, der durch einen Pfeil gekennzeichnet ist. Der Gasstrom hat den Zweck, Ablagerungen des Plasmas an den zweiten Elektroden 7 zu verhindern oder zumindest zu verringern. Durch die poröse Außenschicht 17 wandern Moleküle des Gases hindurch aus den geerdeten zweiten Elektroden 7 heraus. Die austretenden Gasmoleküle hindern ein Ablagern der von der Oberfläche 2 des Substrats 11 reflektierten oder auf andere Weise auf die zweiten Elektroden 7 gelangenden Prozessgasbestandteile. Dadurch kann die Lebensdauer der zweiten Elektroden 7 beträchtlich erhöht werden.

### Bezugszeichenliste

- 1: Vorrichtung
- 2: Oberfläche
- 3: Prozessgaskanal
- 4: erste Elektrode
- 4a: Elektrodenspitze
- 5: Auslass
- 5a: Auslasshöhe
- 5b: Auslasshöhe
- 6: Wechselspannungsquelle
- 7: zweite Elektrode
- 8: Dielektrikum
- 9: Wirkbereich

- 11: Substrat
- 12: Ummantelung
- 13: weiterer Prozessgaskanal
- 14: Seele
- 15: gasdichte Innenschicht
- 16: ringförmiger Gaskanal
- 17: poröse Außenschicht

- B: Breitenrichtung
- H: Höhenrichtung
- L: Längsrichtung

## Patentansprüche

1. Vorrichtung zur Plasmabehandlung von Oberflächen (2) mit
einer ersten Elektrode (4) und
einer zweiten Elektrode (7) und einer Wechselspannungsquelle (6) zwischen erster (4) und zweiter Elektrode (7) und einem mindestens sich zwischen der ersten (4) und zweiten Elektrode (7) ausbildenden elektrischen Feld,
einem vor der ersten Elektrode (4) angeordneten Wirkbereich (9), in dem die zu behandelnde Oberfläche (2) positionierbar ist,
und die zweite Elektrode (7) ist dichter am Wirkbereich (9) angeordnet als die erste Elektrode (4),
**dadurch gekennzeichnet, dass**
wenigstens ein Prozessgaskanal (3) für wenigstens einen Prozessgasstrom mit wenigstens einem Auslass (5) an der ersten Elektrode (4) vorgesehen ist und der wenigstens eine Auslass (5) in Richtung des Wirkbereiches (9) weist und der wenigstens eine Prozessgasstrom das elektrische Feld trifft und das elektrische Feld den wenigstens einen Prozessgasstrom in einen Plasmastrom umwandelt und der Plasmastrom den Wirkbereich (9) trifft.

2. Vorrichtung nach Anspruch 1,
**dadurch gekennzeichnet, dass**
die erste Elektrode (4) stabförmig ausgebildet ist und im Inneren des Prozessgaskanals (3) angeordnet ist.

3. Vorrichtung nach Anspruch 1 oder 2,
**dadurch gekennzeichnet, dass**
die erste Elektrode (4) rohrförmig ausgebildet ist und einen weiteren Prozessgaskanal (13) umschließt und der Prozessgaskanal (3) und der weitere Prozessgaskanal (13) parallel zueinander ausgerichtet sind.

4. Vorrichtung nach einem der Ansprüche 2 oder 3,
**dadurch gekennzeichnet, dass**
die erste Elektrode (4) dichter an den Wirkbereich (9) heranragt als eine Ummantelung (12).

5. Vorrichtung nach Anspruch 2 oder 3,
**dadurch gekennzeichnet, dass**
die Ummantelung (12) dichter an den Wirkbereich (9) heranragt als die erste Elektrode (4).

6. Vorrichtung nach einem der Ansprüche 1 bis 5,
**dadurch gekennzeichnet, dass**
die zweite Elektrode (7) geerdet ist und von einem Dielektrikum (8) umgeben ist.

7. Vorrichtung nach einem der Ansprüche 1 bis 6,
**dadurch gekennzeichnet, dass**
die zweite Elektrode (7) stabförmig ausgebildet ist und von einer gasdichten Innenschicht (15) umgeben ist und zwischen der gasdichten Innenschicht (15) und einer gasdurchlässigen dielektrischen Außenschicht (17) ein Gaskanal (16) vorgesehen ist.

8. Vorrichtung nach einem der vorstehenden Ansprüche,
**dadurch gekennzeichnet, dass**
eine Vielzahl an ersten Elektroden (4) in mehreren jeweils in einer Längsrichtung (L) ausgerichteten Reihen hintereinander angeordnet ist und mehrere stabförmige zweite Elektroden (7) vorgesehen sind, die jeweils entlang einer der Reihen erster Elektroden (4) in Längsrichtung (L) verlaufen.

9. Verfahren zur Behandlung von Oberflächen (2) mit Plasma,
indem zwischen einer ersten Elektrode (4) und einer zweiten Elektrode (7) eine Wechselspannung angelegt wird,
mindestens zwischen den beiden Elektroden (4) ein elektrisches Feld erzeugt wird, vor der ersten Elektrode (4) eine zu behandelnde Oberfläche (2) positioniert wird und die zweite Elektrode (7) dichter an der Oberfläche (2) angeordnet wird als die erste Elektrode (4),
**dadurch gekennzeichnet, dass**
wenigstens ein Prozessgasstrom durch wenigstens einen Prozessgaskanal (3) geführt wird und
der wenigstens eine Prozessgasstrom das elektrische Feld trifft und
das elektrische Feld den wenigstens einen Prozessgasstrom in einen Plasmastrom umwandelt und
der wenigstens eine Prozessgasstrom wenigstens einen am Ende des wenigstens eine Prozessgaskanals (3) vorgesehenen Auslass (5) in Richtung eines Wirkbereiches (9) verlässt und
der Plasmastrom den Wirkbereich (9) trifft.

10. Verfahren nach Anspruch 9,
**dadurch gekennzeichnet, dass**
der Prozessgasstrom die erste stabförmig ausgebildete Elektrode (4) außen umströmt.

11. Verfahren nach Anspruch 9 oder 10,
**dadurch gekennzeichnet, dass**
ein weiterer Prozessgasstrom durch die röhrenförmig ausgebildete erste Elektrode (4) strömt.

12. Verfahren nach einem der Ansprüche 9 bis 11,
**dadurch gekennzeichnet, dass**
ein Gasstrom entlang der zweiten Elektrode (7) strömt und durch eine gasdurchlässige dielektrische Außenschicht (17) nach außen strömt.

13. Verfahren nach einem der Ansprüche 9 bis 12,
**dadurch gekennzeichnet, dass**
ein elektrisches Wechselfeld zwischen der ersten (4) und der zweiten Elektrode (7) erzeugt wird.
